# EUROPEAN PATENT SPECIFICATION

(11) **EP 0 537 364 B1**
(45) Date of publication and mention of the grant of the patent: **16.06.1999**
(21) Application number: 92908472.1
(22) Date of filing: 14.04.1992
(51) Int. Cl.: C23C 14/56, H01L 21/00, H01L 21/68

(54) **APPARATUS AND METHOD FOR MANUFACTURING SEMICONDUCTOR DEVICE**
EINRICHTUNG UND VORRICHTUNG ZUR HERSTELLUNG EINES HALBLEITERBAUELEMENTES
APPAREIL ET PROCEDE DE FABRICATION D'UN DISPOSITIF SEMI-CONDUCTEUR

(30) Priority: 22.04.1991 JP 9061291
(43) Date of publication of application: 21.04.1993
(73) Proprietor: SEMICONDUCTOR PROCESS LABORATORY CO., LTD., Minato-ku, Tokyo 108 (JP); CANON SALES CO., INC., Minato-ku, Tokyo 108 (JP); ALCAN-TECH CO., INC., Tokyo 108 (JP)
(72) Inventor: MAEDA, Kazuo, Semiconductor Process Lab. Co., Ltd., Minato-ku, Tokyo 108 (JP); TOKUMASU, Noboru, Semiconductor Process Lab Co Ltd, Minato-ku, Tokyo 108okyo 108 (JP); NISHIMOTO, Yuhko, Semiconductor Process Lab Co Ltd, Minato-ku, Tokyo 108 (JP)
(74) Representative: Marx, Lothar, Dr.
(86) International application number: PCT/JP92/00468
(87) International publication number: WO 92/19011

(56) References cited:
- EP-A- 0 532 758
- JP-A- 3 054 844
- JP-A- 59 181 648

## Description

### INDUSTRIAL FIELD OF UTILIZATION

The present invention relates to an apparatus for manufacturing a semiconductor device and a method for manufacturing a semiconductor device such as what is called a multistep process apparatus which is capable of forming a single layer film and a multilayer film having improved film quality by performing different types of processings continuously without having a wafer get out in the air.

### PRIOR ART

In an apparatus for manufacturing a very large integrate circuit (VLSI) semiconductor device, the apparatus that incorporates a conception of a multiprocess in which several processings are performed continuously without having the semiconductor device get out in the air has become the main current in recent years, thus making it possible to aim at improvement of the film quality of a formed film and the like and improvement of adhesion among multiple layers of the film. As the combination of processings, for example, film formation and etch back after film formation, processing before oxidation and formation of an oxide film, and continuous formation of a barrier metal film/a metal film may be mentioned.

As representative apparatus for manufacturing a semiconductor device capable of such processing, there are what is called a multi-chamber process apparatus using multi-chambers, a multistep process apparatus or a cluster apparatus in which respective processing sections are arranged in close vicinity to one another and the like.

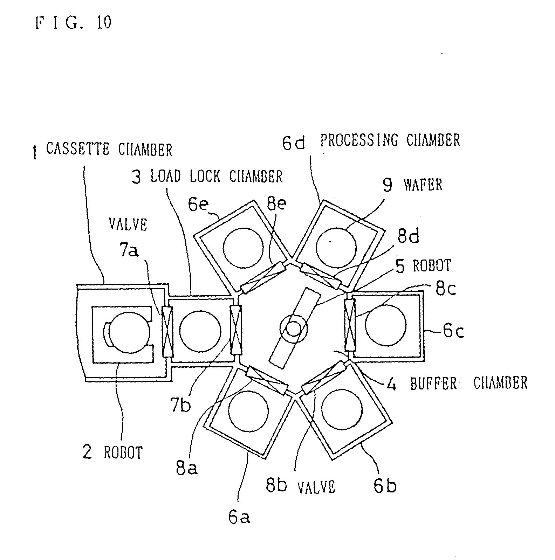

Fig. 10 is a block diagram showing an apparatus for manufacturing a semiconductor device in which an insulating film is formed on a wafer by performing different types of processings continuously using conventional multi-chambers.

In Fig. 10, a reference numeral 1 represents a cassette chamber for preparing for carrying a wafer into and out of the multi-chambers, 3 represents a load-lock chamber for adjusting the pressure among chambers in carrying-in and carrying-out of the wafer, 7a represents a valve for opening and closing a part between the cassette chamber 1 and the load-lock chamber 3, 4 represents a buffer chamber where a robot 5 for carrying the wafer is installed, 7b is a valve for opening and closing a part between the load-lock chamber 3 and the buffer chamber 4, and 6a to 6e represent processing chambers provided radially with the buffer chamber 4 as the center. They are used for the purposes described hereunder. For example:
(1) the processing chamber 6a is used for forming a SiO₂ film (film formation temperature at 400°C) by a plasma chemical vapor deposition (CVD) method;
(2) the processing chamber 6b is used for forming a PSG film (film formation temperature at 400°C) by a low pressure CVD method;
(3) the processing chamber 6c is used for etching back (at room temperature) of a formed film;
(4) the processing chamber 6d is used for forming a Si₃N₄ film (film formation temperature at 400°C) by a plasma CVD method; and
(5) the processing chamber 6e is used for forming a SiO₂ film (film formation temperature at 400°C) by a low pressure CVD method. Besides, heaters not illustrated for maintaining a wafer 9 at the film formation temperature are provided in respective processing chambers 6a to 6e. Further, 8a to 8e represent valves for opening and closing the parts between the buffer chamber 4 and respective processing chambers 6a to 6e. In addition, 2 represents a robot for delivering the wafer 9 from the cassette chamber 1 to a robot not illustrated provided in the load-lock chamber 3.

When a flat multi-layer insulating film composed of SiO₂ film/PSG film is formed using the above-described apparatus for manufacturing a semiconductor device, the wafer 9 moves among the chambers as described hereunder. Namely, the robot 5 carries the wafer 9 into and out of respective processing chambers 6a, 6b and 6c so that respective processings are performed in the order of the processing chamber 6a/the processing chamber 6b/the processing chamber 6c.

Now, the heaters for heating and maintaining the wafer 9 at the film formation temperature are provided in respective processing chambers 6a, 6b and 6c, and the temperature of the wafer 9 varies between the room temperature and the film formation temperature while the wafer 9 moves among the processing chambers 6a, 6b and 6c. In the above-described example for instance, the temperature varies like 25°C/400°C/25°C/400°C/25°C. As a result, there is such a problem that the wafer 9 is subject to a certain type of temperature cycle, degradation and deterioration of the film quality of the formed CVD film or generation of a stress to the formed film and the like are caused.

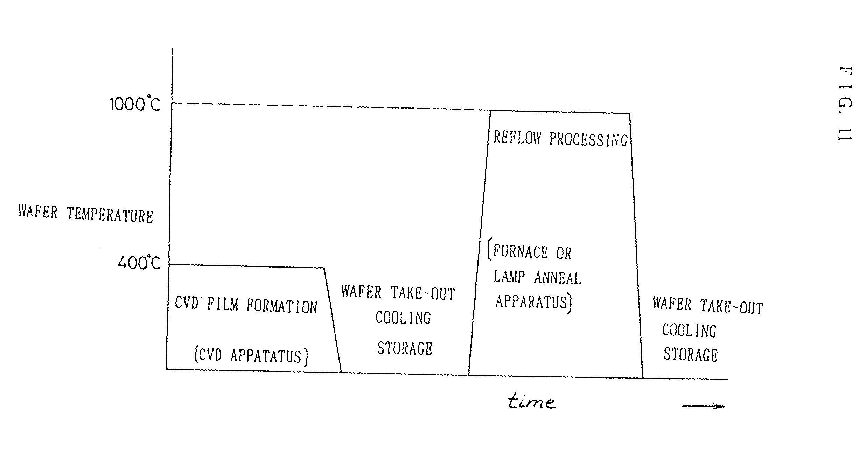

Further, in a process requiring annealing after forming a CVD film, the wafer is taken out and housed in a cassette once after forming a CVD film, and the cassette is moved and inserted into a heating furnace, thereafter so as to apply heat processing. Temperature hysteresis of a wafer in such a case is shown in Fig. 11.

In this case, there is also a problem that the wafer temperature varies more sharply than a conventional example shown in Fig. 10 from the room temperature to 1,000°C.

From EP-A-0 532 758, a semiconductor manufacturing equipment is known, which has only a film forming gas dispersion unit but does not comprise processing means for processing a formed film, such as ultraviolet ray radiation means or infrared ray radiation means.

JP-A-3-54844 discloses transporting means provided with heating means and a plurality of processing portions provided each with another heating means. The transporting means carry a wafer to each processing portion and then transfers it thereto. The wafer is heated separately by the heating means of each processing portion during processing.

It is an object of the present invention which has been made in view of such conventional problems to provide an apparatus for manufacturing a semiconductor device and a method for manufacturing a semiconductor device that are capable of preventing thermal distortion and the like from generating and also preventing variation and deterioration of the film quality of the formed film by reducing the variation of the wafer temperature while different types of processings are performed successively.

### DISCLOSURE OF THE INVENTION

The above object is attained by an apparatus according to claim 1 and methods according to claims 3 and 4. The subclaim 2 defines an advantageous embodiment of the invention.

In case of performing, after forming a film in the film forming section, other processings at other locations, i.e., in case of performing reflow processing of a film, processing by radiating ultraviolet rays (UV), or anneal processing in a ozone gas atmosphere in the processing section by means for radiating infrared rays, means for radiating ultraviolet rays or means for supplying ozone gas, it is possible to reduce temperature variation of the wafer by preventing natural cooling of the wafer during movement by heating the wafer with the heating means in all cases.

When different types of plurality of films are formed on the wafer, it is possible to maintain the wafer temperature at the forming temperature of one film for instance during the period of moving the wafer for forming other films after forming the one film. Thus, it is possible to reduce variation of the wafer temperature by preventing natural cooling during the movement of the wafer and to prevent change and deterioration of the film quality of the formed film by preventing generation of thermal distortion and the like in the formed film.

It is possible to perform processing continuously without lowering the wafer temperature as being done in the past. Thus, it is possible to reduce variation of the wafer temperature. As a result, it is possible to prevent generation of thermal distortion in the formed film, thereby to prevent change and deterioration of the film quality of the formed film.

### BRIEF DESCRIPTION OF THE DRAWINGS

Fig. 1 is a block diagram for explaining a multistep process apparatus showing a first embodiment of the present invention;
Fig. 2 is a perspective view for explaining a multistep process apparatus showing a second embodiment of the present invention;
Fig. 3 shows block diagrams for explaining a film forming section and a processing section of a multistep process apparatus according to the second embodiment of the present invention;
Fig. 4 is a top view for explaining a multistep process apparatus according to the second embodiment of the present invention;
Fig. 5 shows sectional views for explaining a method for forming a film according to a third embodiment of the present invention;
Fig. 6 is a diagram for explaining hysteresis of the wafer temperature in a method for forming a film according to the third embodiment of the present invention;
Fig. 7 shows sectional views (1/2) for explaining a method for forming a film according to a fourth embodiment of the present invention;
Fig. 8 shows sectional views (2/2) for explaining a method for forming a film according to the fourth embodiment of the present invention;
Fig. 9 is a diagram for explaining hysteresis of the wafer temperature in a method for forming a film according to the fourth embodiment of the present invention;
Fig. 10 is a block diagram for explaining a conventional multi-chamber process apparatus; and
Fig. 11 is a diagram for explaining hysteresis of the wafer temperature in a conventional method for forming a film.

### BEST MODES OF EMBODIMENTS OF THE INVENTION

Embodiments of the present invention will be described hereinafter with reference to the drawings.

### (1) Apparatus for manufacturing a semiconductor device according to embodiments of the present invention

### (a) The first embodiment

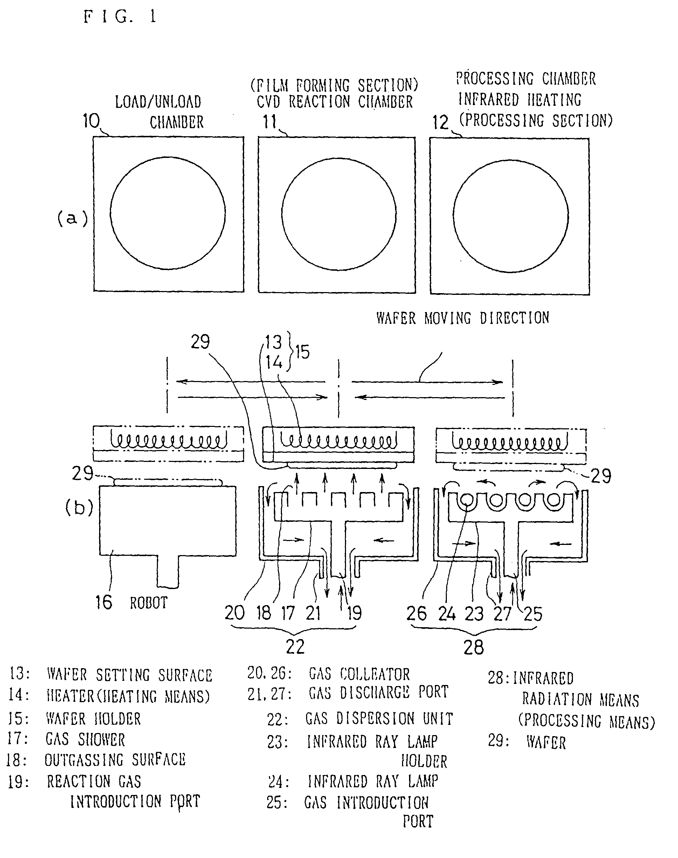

Figs. 1(a) and (b) show what is called a multi step process apparatus of the first embodiment of the present invention, in which Fig. 1(a) is a plan view and Fig. 1(b) is a side view.

In a multistep process apparatus shown in Figs. 1(a) and (b), a load/unload chamber 10, a CVD reaction chamber (a film forming section) 11 and an infrared heat processing chamber (a processing section) 12 are connected in this arrangement, a BPSG film is formed by a CVD method on a wafer surface held with the face downward in order to prevent contamination due to dust and the like, and reflow processing is performed further, thereby making it possible to flatten the wafer surface. Besides, valves for opening and closing partition walls among respective chambers and the portions among respective chambers are provided sometimes.

A reference numeral 16 in the figure represents a robot provided in the load/unload chamber 10, and carries in and carries out a wafer 29 from the outside of the load/unload chamber 10.

22 represents a gas dispersion unit provided in the CVD reaction chamber 11, which introduces reaction gas through a reaction gas introduction port 19 and discharges reaction gas upwards from an outgassing surface of a gas shower 17. Then, the reaction gas which has completed reaction is collected by a gas collector 20 surrounding the peripheral part of the gas shower 17 and exhausted outside the CVD reaction chamber 11 through a gas discharge port 21.

28 represents infrared radiation means (processing means) provided in the infrared heat processing chamber 12, and an infrared ray lamps 24 are held by an infrared ray lamp holder 23 having a gas introduction port 25 for introducing inert gas discharged onto the wafer 29 for preventing oxidation. The inert gas dispersed on the surface of the wafer 29 is collected by the gas collector provided around the infrared ray lamp holder 23, and is discharged outside the infrared heat processing chamber 12 through a gas exhaust port 27.

15 represents a wafer holder for holding the wafer 29 with the face downward for preventing contamination due to dust and the like, which comes and goes among the load/unload chamber 10, the CVD reaction chamber 11 and the infrared heat processing chamber 12 while holding the wafer 29 as it is. Further, a heater (heating means) 14 is buried in the wafer holder 15 so as to heat and maintain the wafer 29 placed on a wafer setting surface 13 at a predetermined temperature.

As described above, in a multistep process apparatus of the first embodiment of the present invention, the CVD reaction chamber 11 having the gas dispersion unit 22 for supplying the reaction gas onto the wafer 29, an infrared heat processing chamber 12 for heating and reflowing a film such as a formed BPSG film, and the wafer holder 15 capable of moving between the CVD reaction chamber 11 and the infrared heat processing chamber 12 successively while holding the wafer 29 as it is are provided, and the wafer holder 15 has the heater 14 capable of heating the wafer 29 including the period while the wafer 29 is moving.

Accordingly, when reflow processing of a BPSG film is performed by the infrared radiation means 28 in the infrared heat processing chamber 12 after a film such as a BPSG film is formed in the CVD reaction chamber 11, it is possible to maintain the wafer temperature at a predetermined temperature by adjusting heating by means of the heater 14. Thus, it is possible to reduce the temperature variation of the wafer 29.

Besides, in the first embodiment, the infrared heat processing chamber 12 is connected to the CVD reaction chamber 11, but a UV processing chamber (an ultraviolet processing chamber) or an ozone processing chamber may be connected in place of the infrared heat processing chamber 12. With this, it is possible to densify a film such as a BPSG film by filling with dangling bond, and also to prevent generation of thermal distortion in a formed film by reducing temperature variation of the wafer 29, thereby to aim at improvement of the film quality.

### (b) The second embodiment

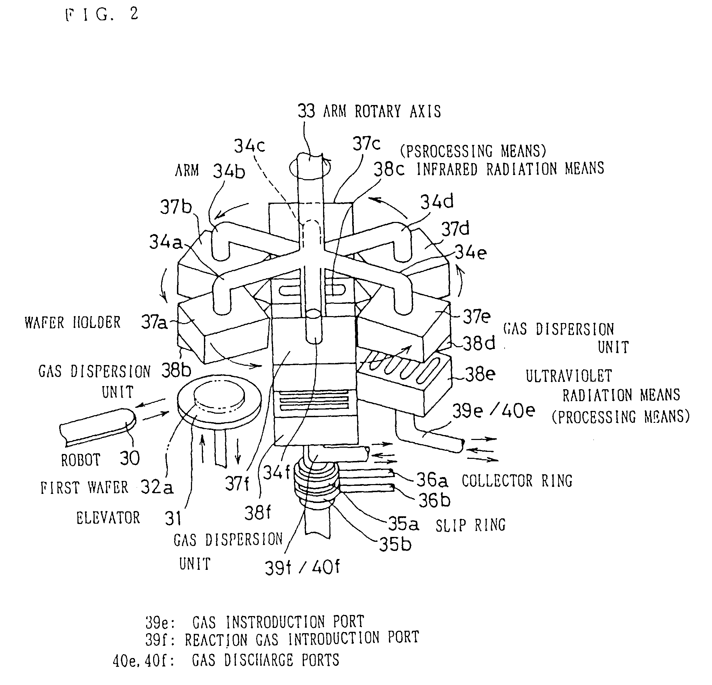

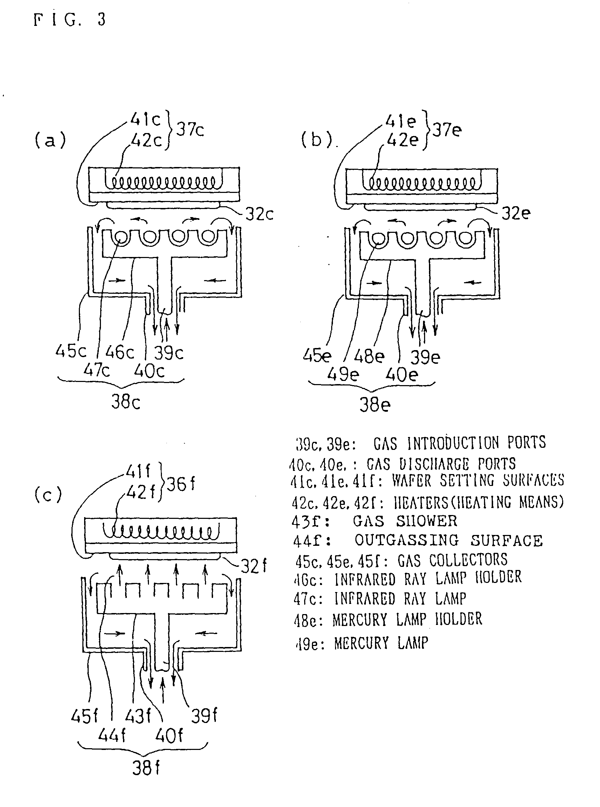

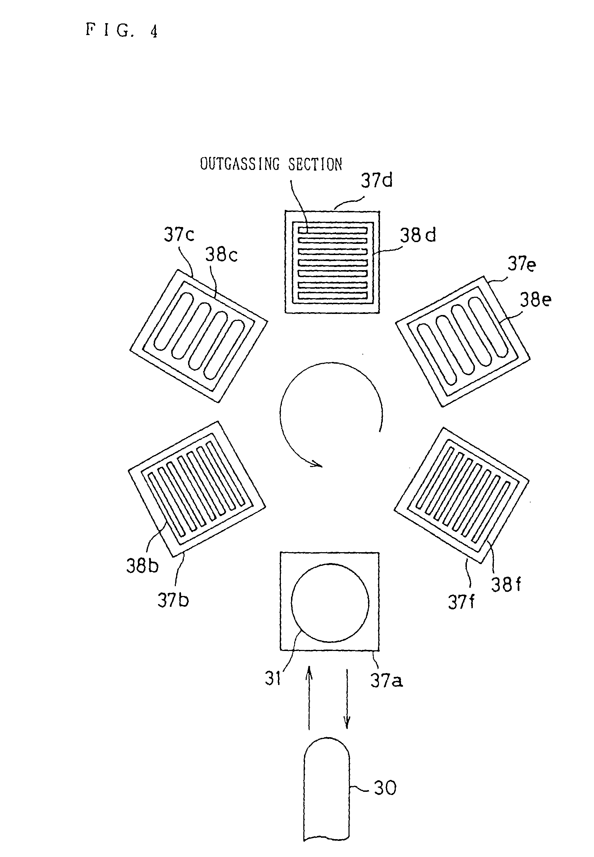

Fig. 2, Figs. 3(a) to (c) and Fig. 4 are views for explaining a multistep process apparatus according to a second embodiment of the present invention, in which Fig. 2 is a perspective view of the whole apparatus, Figs. 3(a) to (c) show side views of the infrared radiation means, the ultraviolet radiation means and the gas dispersion unit, and Fig. 4 is a top view of the whole apparatus, respectively.

In Fig. 2, Figs. 3(a) to (c) and Fig. 6, what distinguishes them from Figs. 1(a) and (b) is that the CVD reaction chamber and respective processing chambers are arranged along the circumference with the rotary shaft as the center, and a wafer holder having a heater (heating means) also moves along the circumference in accordance with the above. In this multistep process apparatus, it is possible to form, for example, an insulating film having a 3-layer construction in which a BPSG film flattened by reflow is put between SiO₂ films.

In Fig. 2, Figs. 3(a) to (c) and Fig. 4, 37a to 37f shown in Figs. 3(a) to (c) represent wafer holders which are separated from one another, and respective wafer holders 37a to 37f are fixed to the rotary shaft 33 by means of arms 34a to 34f. Further, wafer setting surfaces 41a to 41f of the wafer holders 37a to 37f are rotated around the rotary shaft 33 on a plane including wafer setting surfaces 41a to 41f of respective wafer holders 37a to 37f by rotating the rotary shaft 33. Also, respective wafer holders 37a to 37f are connected to an exhaust unit not illustrated, and fixed wafers 32a to 32f to the wafer setting surfaces 41a to 41f and/or separate the fixed wafers 32a to 32f from the wafer setting surfaces 41a to 41f by means of chucks which communicate with a suction port and an introduction port of nitrogen gas not illustrated through pipe-shaped arms 34a to 34f. Further, heaters (heating means) 42a to 42f are buried in respective wafer holders 37a to 37f individually, and electric power is supplied independently to respective heaters 42a to 42f so that heating and thermal insulation of the wafers 32a to 32f placed on respective wafer holders 37a to 37f may be performed individually.

38b to 38f represent a gas dispersion unit of a first film forming section/infrared radiation means (processing means) of the first processing section/a gas dispersion unit of a second film forming section/ ultraviolet radiation means (processing means) of the second processing section/a gas dispersion unit of the third film forming section which are provided so as to oppose to the wafer setting surfaces 41b to 41f of the wafer holders 37b to 37f. 38b to 38f are separated from the wafer holders 37b to 37f and fixed to a base of an apparatus not illustrated along the circumstance with the rotary shaft 33 as the center.

Respective gas dispersion units 38b, 38d and 38f have gas showers 43b, 43d and 43f for supplying the reaction gas to the wafers 32b, 32d and 32f and gas collectors 45b, 45d and 45f for collecting the gas in which reaction is completed, and reaction gas introduction ports 39b, 39d and 39f are connected to the gas showers 43b, 43d and 43f, and the gas discharge ports 40b, 40d and 40f are connected to the gas collectors 45b, 45d and 45f as shown typically by the gas dispersion unit 38f shown in Fig. 3(c). Furthermore, as shown in Fig. 4, the gas discharge sections of respective gas dispersion units 38b, 38d and 38f are provided by being split into a plurality of slits in a direction perpendicular to the radial direction with the rotary shaft 33 as the center.

Further, as shown in Fig. 3(a), infrared radiation means 38c includes an infrared ray lamp 47c for heating the wafer 32c, an infrared ray lamp holder 46c for holding the infrared ray lamp 47c, and a gas collector 45c for collecting inert gas discharged onto the wafer for preventing oxidation, and a gas introduction port 39c is connected to the infrared ray lamp holder 46c and a gas discharge port 40c is connected to a gas collector 45c. Furthermore, as shown in Fig. 3(b), ultraviolet radiation means 38e includes mercury lamps 49e for heating the wafer 32e, a mercury lamp holder 48e for holding the mercury lamps 49e and a gas collector 45e for collecting inert gas discharged onto the wafer for preventing oxidation, and a gas introduction port 39e is connected to the mercury lamp holder 48e and a gas discharge port 40e is connected to the gas collector 45e.

Furthermore, slip rings 35a and 35b shown in Fig. 2 connected to the heater 42a are connected to a pair of collector rings 36a and 36b which are in contact with the slip rings 35a and 35b provided on the rotary shaft 33 and rotating along with the rotary shaft 33 so as to correspond to positive and negative polarities thereof. Further, the pair of collector rings 36a and 36b are connected to a power source not illustrated so that electric power may be supplied to the heaters 42a to 42f through the slip rings 35a and 35b. Besides, only the slip rings 35a and 35b connected to the heater 42a of one wafer holder 37a are illustrated In Fig. 2, but slip rings connected to the heaters 42b to 42f of other wafer holders 37b to 37f are also provided on the rotary shaft 33. Further, rotary connectors are used for both slip rings 35a and 35b so that the rotation of the rotary shaft 33 is not prevented.

Besides, the position of the wafer holder 37a is a loader/unloader section where an elevator 31 is installed as shown in Fig. 2, and the wafer 32a is delivered between the elevator 31 and the wafer holder 37a only, and no film is formed.

In a multistep process apparatus of the second embodiment as described above, it becomes possible to form different types of multilayer films by providing the gas dispersion units 38b, 38d and 38f in plural numbers and separately from one another. Further, the infrared radiation means 38c and the ultraviolet radiation means 38e being provided, it is possible to perform formation of a flat insulating film, processing for flattening a formed film and processing for improvement of the film quality of a formed film continuously.

Besides, in the above-described second embodiment, the infrared radiation means 38c and the ultraviolet radiation means 38e are provided as processing means, but means for supplying processing gas such as ozone may be provided in place of these means, and furthermore, it is possible to increase the processing sections and to provide processing gas supplying means in addition to the infrared radiation means 38c and the ultraviolet radiation means 38e.

Further, the film forming section and the processing section are provided in a mixed state, but only the film forming section may be provided alone.

Furthermore, the wafer setting surfaces 41a to 41f with the faces thereof downward are provided, but the same is also applicable to that which has the wafer setting surfaces with the faces thereof upward.

### (2) A method for manufacturing a semiconductor device according to an embodiment of the present invention

### (c) The third embodiment

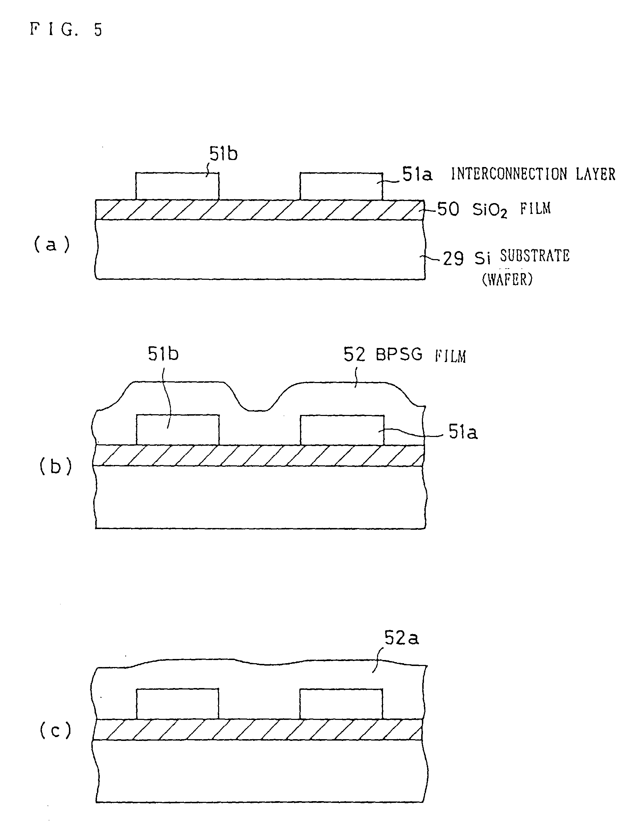

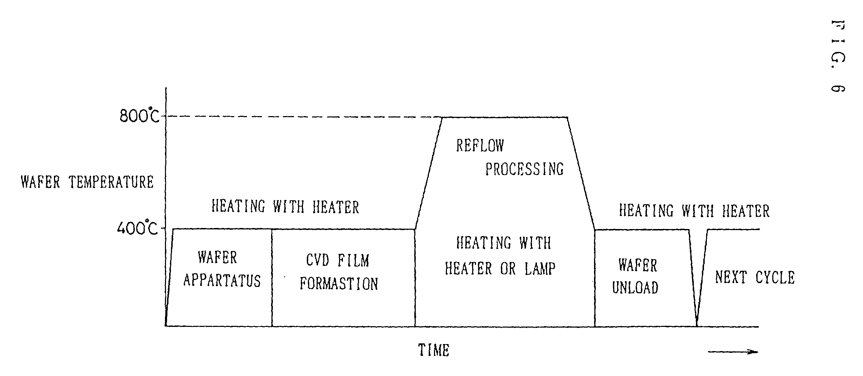

Next, a manufacturing method according to a third embodiment in which a flattened BPSG film is formed on a wafer surface using a multistep process apparatus shown in Figs. 1(a) and (b) will be described with reference to Figs. 5(a) to (c) and Fig. 6. Figs. 5(a) to (c) show sectional views for explaining a manufacturing method and Fig. 6 is a diagram showing hysteresis of the wafer temperature during film formation processing including the wafer temperature during movement.

First, a Si substrate (wafer) 29 shown in Fig. 5(a) on which interconnection layers 51a and 51b composed of a polysilicon film are formed on a SiO₂ film 50 is placed with the face thereof downward on the wafer setting surface 13 of the wafer holder 15 after carrying the Si substrate 29 in the load/unload chamber 10 by the robot 16 shown in Fig. 1(b).

Next, electric current is applied to the heater 14 buried in the wafer holder 15 so as to run the heater 14 hot, thereby to heat the wafer 29 to maintain the wafer temperature (the first temperature)at 400°C.

Then, the wafer holder 15 is moved so as to carry the wafer 29 to the CVD reaction chamber 11. At this time, electric current is also applied to the heater 14 during conveyance, thereby to run the heater 14 hot so that the wafer temperature is maintained at 400°C. Then, when mixed gas of TEOS/Tri-Methyl-Phosphate (TMP) containing phosphorus at 3.5 weight percentage/Tri-Methyl-Borate (TMB) containing boron at 4.0 weight percentage/O₃ is introduced into the gas shower 17 from the reaction gas introduction port 19, the mixed gas is discharged from the outgassing surface 18 onto the surface of the wafer 29. Therefore, when such a state is maintained for a predetermined period of time, a BPSG film 52 having a predetermined film thickness is formed (Fig. 5(b)).

Then, the wafer holder 15 is moved to the infrared heat processing chamber 12. At this time, electric current is also applied to the heater 14 during conveyance of the wafer similarly to the time of movement described above, thereby to run the heater 14 hot so that the wafer temperature is maintained at 400°C.

Then, the wafer 29 carried into the infrared heat processing chamber 12 is heated further by an infrared ray lamp 24 in nitrogen gas introduced through a gas introduction port 25 and is maintained at the temperature (the second temperature) of 800°C. As a result, the BPSG film 52 melts and flows, and the surface of the wafer 29 is flattened (Fig. 5(c)). At this time, the heat processing temperature could be lowered by approximately 100 to 200°C as compared with a conventional method for performing heat processing again in a heat processing furnace after the wafer is cooled naturally because the wafer is transferred from the CVD apparatus to the heat processing furnace. This is conceivable to be by reason of that, since the temperature of the wafer 29 is maintained at a predetermined temperature or higher, it is possible to prevent the film quality of the BPSG film 52 from changing and to prevent moisture absorption of the BPSG film 52.

As described above, in the manufacturing method of the third embodiment, as shown in the hysteresis of the wafer temperature shown in Fig. 6, the wafer 29 held by the wafer holder 15 having the heater 14 is heated by means of the heater 14 and is maintained at the temperature of 400°C so as to form the BPSG film 52 on the surface of the wafer 29. Thereafter, the wafer 29 is heated by infrared radiation in addition to heating by the heater so as to rise the temperature of the wafer 29 from approximately 400°C to approximately 800°C for performing reflow processing of the BPSG film 52.

Accordingly, since it is possible to perform reflow processing of the BPSG film 52 continuously after the BPSG film 52 is formed without lowering the temperature of the wafer 29, the variation of the temperature of the wafer 29 can be reduced. With this, it is possible to aim at flattening of the BPSG film 52 and to prevent generation of thermal distortion in the BPSG film 52, thus preventing change and deterioration of the film quality of the BPSG film 52.

Further, reflow processing of the BPSG film 52 is performed after forming the BPSG film 52, but it is also possible to convey the wafer 29 while continuing heating of the wafer 29 after forming the BPSG film 52, and to perform UV radiation processing and annealing processing in an ozone atmosphere of the BPSG film 52 continuously on the wafer 29 maintained at a constant temperature. With this, it is possible to densify the BPSG film 52 by filling dangling bond, and also to reduce temperature variation of the wafer 29 between the time of processing and the time of conveyance so as to prevent generation of thermal distortion in the BPSG film 52, thus aiming at improvement of the film quality.

### (d) The fourth embodiment

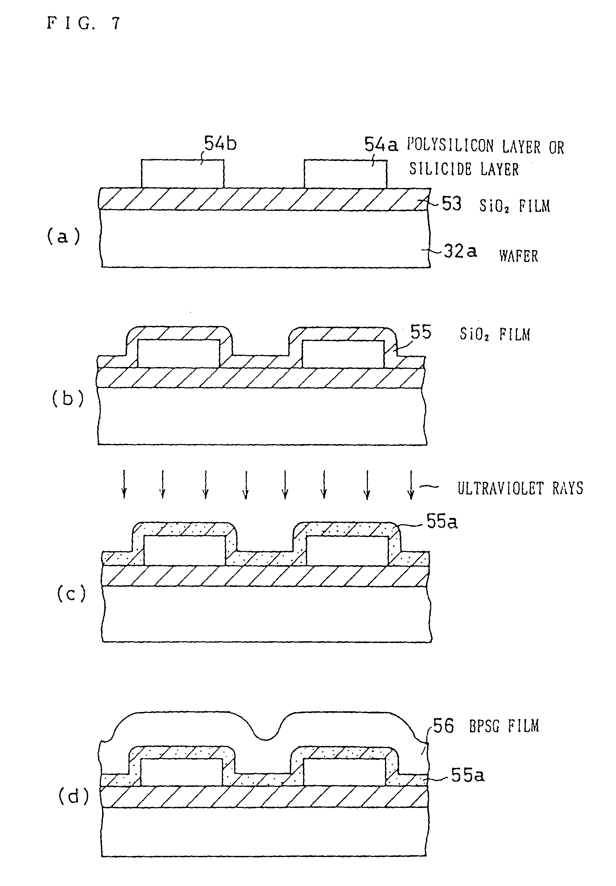

Next, a method for forming an insulating film in three layers according to a fourth embodiment of the present invention using the multistep process apparatus shown in Fig. 2 will be described with reference to Figs. 7(a) to (d), Figs. 8(e) to (g) and Fig. 9.

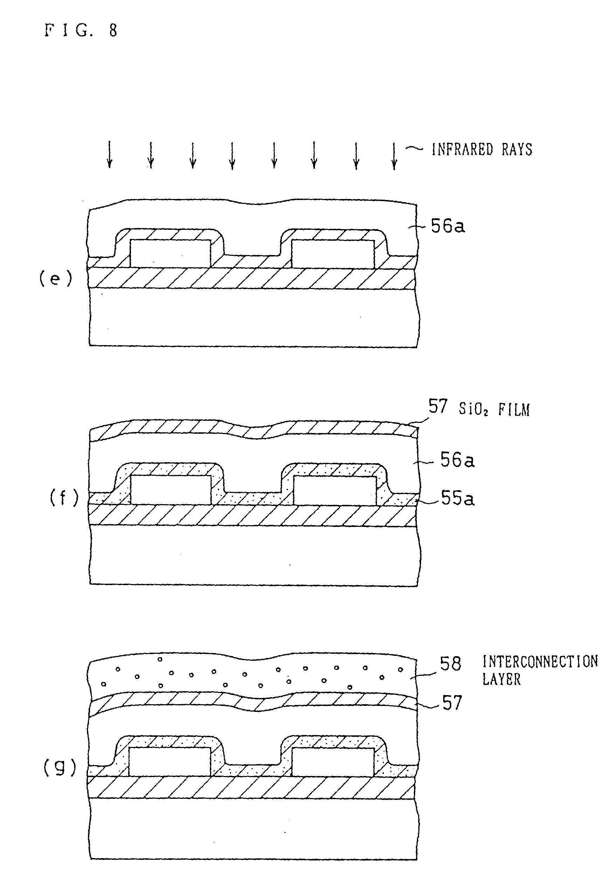

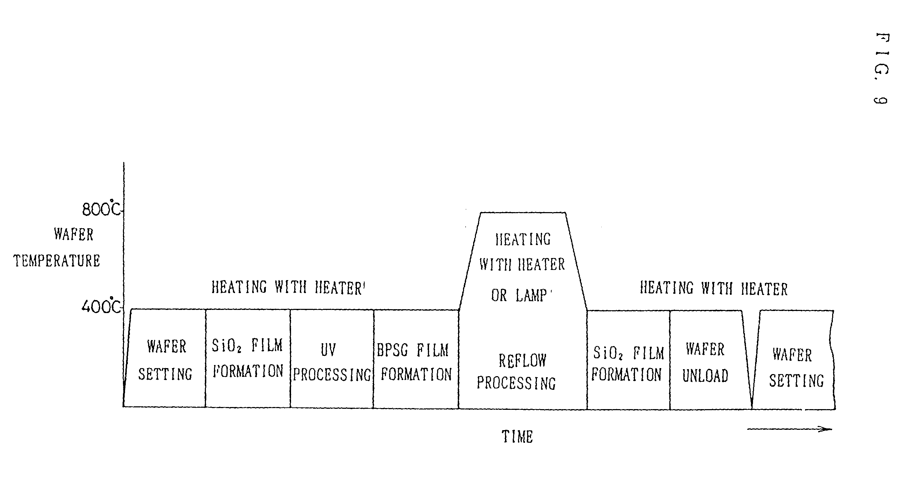

Figs. 7(a) to (d) and Figs. 8(e) to (g) are sectional views for explaining the manufacturing method, and Fig. 9 is a diagram showing the hysteresis of the wafer temperature during film formation processing including the temperature of the wafer during movement. In this case, as shown in Fig. 8(f), an insulating film having a three-layer construction of SiO₂ film 55a/BPSG film 56a/SiO₂ film 57 having a predetermined film thickness is formed on the wafer while the wafer holder 37a goes round the rotary shaft 33. Besides, the SiO₂ film 55a in the lowest layer is formed for the purpose of preventing a resistance value from fluctuating by the introduction of boron (B) and phosphorus (P) in the BPSG film 56a into polysilicon layers or silicide layers 54a and 54b, and the SiO₂ film 57 in the uppermost layer is formed for the purpose of preventing moisture absorption of the BPSG film 56a.

First, a first wafer 32a on which polysilicon layers or silicide layers 54a and 54b are formed on a SiO₂ film 53 shown in Fig. 7(a) is conveyed to the loader/ unloader section and placed on the elevator 31 by means of a robot 30 shown in Fig. 2.

Then, the elevator 31 is lifted so as to bring the first wafer 32a into contact with a wafer setting surface 41a of the wafer holder 37a, and air is exhausted through a suction port not illustrated so as to place and fix the first wafer 32a onto the wafer setting surface 41a by means of a chuck communicating with the suction port. At this time, electric power is supplied to heaters 42a to 42f of all the wafer holders 37a to 37f through slip rings 35a, 35b, .../collector rings 36a, 36b, ... corresponding to heaters 42a to 42f of respective wafer holders 37a to 37f, and the temperature of the wafer setting surfaces 41a to 41f of all the wafer holders 37a to 37f is maintained at approximately 400°C.

Next, after the temperature of the first wafer 32a reaches to approximately 400°C, the rotary shaft 33 is rotated and the wafer holder 37a is stopped at a position right above a gas dispersion unit 38f. Then, the mixed gas of TEOS-O₃ is discharged from the gas shower 43f as reaction gas. At this time, a SiO₂ film 55 starts to grow, but the growth rate reaches to approximately 200 nm (2,000Å). The SiO₂ film 55 having a target film thickness of approximately 200 nm (2,000Å) is formed on the first wafer 32a (Fig. 7(b)) by maintaining such a state for about one minute. Besides, in the interim, a second wafer 32b is placed on the wafer holder 37b positioned at the loader/unloader section similarly to the above, and the second wafer 32b is heated beforehand to reach the temperature at approximately 400°C by means of the heater 42b.

Next, the rotary shaft 33 is rotated, and the wafer holders 37b and 37a are stopped at positions right above the gas dispersion unit 38f/the ultraviolet radiation means 38e, respectively. At this time, the first and the second wafers 32a and 32b are also heated by means of the heaters 42a and 42b during movement so that the first and the second wafers 32a and 32b are maintained beforehand at the temperature of approximately 400°C as shown in Fig. 9. In this state, a mercury lamp 49e of the ultraviolet radiation means 38e is lighted so as to radiate ultraviolet rays onto the SiO₂ film 55 on the first wafer 32a. As a result, it is possible to fill dangling bond of the SiO₂ film 55 so as to densify the SiO₂ film 55a (Fig. 7(c)). On the other hand, the mixed gas of TEOS-O₃ is discharged from the gas shower 43f as reaction gas, and, when this state is maintained for about one minute, a SiO₂ film having a target film thickness of approximately 200 nm (2,000Å) is formed on the second wafer 32b. Furthermore, in the interim, a third wafer 32c is placed on the wafer holder 37c positioned at the loader/unloader section similarly to the above, and the third wafer 32c is heated beforehand to the temperature of approximately 400°C by means of the heater 42c.

Then, the rotary shaft 33 is rotated, and the wafer holders 37c, 37b and 37a are stopped at positions right above the gas dispersion unit 38f/the ultraviolet radiation means 38e/the gas dispersion unit 38d, respectively. At this time, the first, the second and the third wafers 32a, 32b and 32c are also heated by the heaters 42a to 42c during movement so as to maintain the first, the second and the third wafers at the temperature of approximately 400°C as shown in Fig. 9. When mixed gas of TEOS-O₃/TMP/TMB is discharged immediately in this state from the gas shower 43d of the gas dispersion unit 38d as reaction gas, and, when this state is maintained for about three minutes, a BPSG film 56 having a target film thickness of approximately 600 nm (6,000Å) is formed on the SiO₂ film 55 of the first wafer 32a (Fig. 7(d)). On the other hand, the mercury lamp 49e is lighted so as to radiate ultraviolet rays onto the SiO₂ film on the second wafer 32b. As a result, it is possible to fill dangling bond of the SiO₂ film so as to densify the SiO₂ film. Furthermore, a SiO₂ film having a target film thickness of approximately 200 nm (2,000Å) is formed on the third wafer 32c by discharging reaction gas from the gas dispersion unit 38f. Moreover, in the interim, a fourth wafer 32d is placed on the wafer holder 37d positioned at the loader/unloader section similarly to the above, and the fourth wafer 32d is heated to the temperature of approximately 400°C by means of the heater 42d.

Next, the rotary shaft 33 is rotated, and the wafer holders 37d, 37c, 37b and 37a are stopped at positions right above the gas dispersion unit 38f/the ultraviolet radiation means 38e/the gas dispersion unit 38d/the infrared radiation means 38c, respectively. At this time, the first, the second, the third and the fourth wafers 32a, 32b, 32c and 32d are also heated during movement by means of the heaters 42a to 42d, and the first, the second, the third and the fourth wafers 32a, 32b, 32c and 32d are maintained beforehand at the temperature of approximately 400°C as shown in Fig. 9. Then, in order to reflow the BPSG film 56 on the first wafer 32a, an infrared ray lamp 38c is lighted, and the wafer temperature is risen from approximately 400°C to approximately 800°C and maintained there as shown in Fig. 9. When this state is maintained for a predetermined period of time, the BPSG film 56 melts and flows, and the unevenness of the wafer surface is levelled (Fig. 7(e)). Besides, predetermined processings are performed also on the second, the third and the fourth wafers 32b, 32c and 32d simultaneously with the processing of the first wafer 32a. Furthermore, in the interim, a fifth wafer 32e is placed on the wafer holder 37e positioned at the loader/unloader section similarly to the above, and the fourth wafer 32e is heated to the temperature of approximately 400°C beforehand by means of the heater 42e.

Then, the rotary shaft 33 is rotated, and the wafer holders 37e, 37d, 37c, 37b and 37a are stopped at positions right above the gas dispersion unit 38f/the ultraviolet radiation means 38e/the gas dispersion unit 38d/the infrared radiation means 38c/the gas dispersion unit 38b, respectively. At this time, the first, the second, the third, the fourth and the fifth wafers 32a, 32b, 32c, 32d and 32e are also heated during movement by means of the heaters 42a to 42e so as to maintain the first, the second, the third, the fourth and the fifth wafers 32a, 32b, 32c, 32d and 32e at the temperature of approximately 400°C beforehand. Then, the mixed gas of TEOS-O₃ is discharged from the gas shower 43b of the gas dispersion unit 38b as reaction gas, and when this state is maintained for about one minute, a SiO₂ film 57 having a target film thickness of approximately 200 nm (2,000Å) is formed on the first wafer 32a (Fig. 7(f)). Besides, predetermined processings are applied also to the second, the third, the fourth and the fifth wafers 32b, 32c, 32d and 32e simultaneously with the processing of the first wafer 32a. Furthermore, in the interim, a sixth wafer 32f is placed on the wafer holder 37f positioned at the loader/unloader section similarly to the above, and the sixth wafer 32f is heated beforehand to the temperature of approximately 400°C by means of the heater 42f.

Then, the rotary shaft 33 is rotated, and the wafer holders 37f, 37e, 37d, 37c, 37b and 37a are stopped at positions right above the gas dispersion unit 38f/the ultraviolet radiation means 38e/the gas dispersion unit 38d/the infrared radiation means 38c/the gas dispersion unit 38b/the elevator 31, respectively. Then, when the elevator 31 is lifted, the suction port corresponding to the chuck of the wafer holder 37a is closed, and the valve at the introduction port of nitrogen gas is opened so as to supply the nitrogen gas to the chuck, the first wafer 32a is separated from the wafer setting surfaces 41a and is placed on the elevator 31. Next, the first wafer 32a is carried out to the cassette station by means of the robot 30. Besides, in the interim, predetermined processings are also applied to the second, the third, the fourth, the fifth and the sixth wafers 32b, 32c, 32d, 32e and 32f simultaneously with the processing of the first wafer 32a.

In such a manner, similar processing to that for the first wafer 32a is also performed to the second, the third, the fourth, the fifth and the sixth wafers 32b, 32c, 32d, 32e and 32f. Thus, when the second, the third, the fourth and the fifth wafers 32b, 32c, 32d and 32e return to the loader/unloader section again after going round the rotary shaft 33, a film in three layers of SiO₂ film/BPSG film/SiO_{2,}film having a target film thickness has been formed on these wafers. The wafers are heated by means of the heaters 42b to 42e in the interim, and always maintained at a constant temperature. Therefore, it is possible to prevent generation of thermal distortion on the formed film due to temperature variation. In such a way, a film in three layers of SiO₂ film/BPSG film/SiO₂ film each having a predetermined film thickness is formed on the wafer one after another and accumulated in the cassette station.

When an interconnection layer 58 in an upper layer composed of an Aℓ film is formed thereafter after a via hole not illustrated is formed in the SiO₂ film 57 and a BPSG film 56a on interconnection layers 54a and 54b in a lower layer, a semiconductor device is completed (Fig. 7(g)).

As described above, according to the method for manufacturing a semiconductor device of the fourth embodiment, the first, the second, the third, the fourth, the fifth and the sixth wafers 32a, 32b, 32c, 32d, 32e and 32f held by the wafer holders 37a, 37b, 37c, 37d, 37e and 37f having heaters 42a to 42f are moved between the gas dispersion units 38b, 38d and 38f and respective processing sections 38c and 38e while heating these wafers and maintaining them at the temperature of approximately 400°C, thereby to form SiO₂ film 55a radiated with ultraviolet rays/BPSG film 56a flattened by infrared radiation/SiO₂ film 57 on the surfaces of the wafers 32a, 32b, 32c, 32d, 32e and 32f.

Accordingly, the wafer temperature only fluctuates between 400°C and 800°C as shown in Fig. 9. Since it is possible to reduce the variation of the wafer temperature by preventing the wafers 32a, 32b, 32c, 32d, 32e and 32f from being cooled naturally during movement as in the past, it is possible to prevent change and deterioration of the film quality of the formed film in such a manner that thermal distortion is reduced and so on.

Besides, the SiO₂ film 55a radiated with ultraviolet rays is formed as a SiO₂ film in a lowermost layer in the fourth embodiment, but it is also possible to form a SiO₂ film applied with annealing processing in an ozone atmosphere. Further, it is possible to form not only a film having the film thickness in the fourth embodiment, but also to form a film having another constructions by combining film formation, infrared processing, ultraviolet processing, annealing processing in an ozone atmosphere and the like.

Further, film formation and processing of a formed film are performed, but it is also possible to form a film composed of different types of multilayers of SiO₂ film/BPSG film/SiO₂ film without processing a formed film. In this case, it is also possible to reduce variation of the wafer temperature by heating the wafer while the wafer holder is moved among film forming sections. Thus, it is possible to aim at reduction of thermal distortion of the formed insulating film.

Furthermore, it is possible to unify supply of reaction gas onto the wafers 32a to 32f thereby to form SiO₂ film/BPSG film/SiO₂ film each having uniform film thickness and film quality by having the wafer holders 37a to 37f perform rectilinear reciprocating motion by means of oscillation units radially with the positions of the held wafer holders 37a to 37f as the center during film formation.

### INDUSTRIAL AVAILABILITY

As described above, an apparatus for manufacturing a semiconductor device and a method for manufacturing a semiconductor device according to the present invention are useful as an apparatus for manufacturing a semiconductor device and a method for manufacturing a semiconductor device such as what is called a multistep process apparatus which is capable of forming a film in a single layer having an improved film quality by performing different types of processings continuously without having the wafers get out in the air.

### DESCRIPTION OF REFERENCE NUMERALS

1 ... cassette chamber; 2, 5, 16, 30 ... robots; 3 ... load lock chamber; 4 ... buffer chamber; 6a - 6e ... processing chambers; 7a, 7b, 8a - 8e ... valves; 9, 29, 32a - 32f ... Si substrates (wafers); 10 ... load/unload chamber; 11 ... CVD chamber (film forming section); 12 ... infrared heat processing chamber (processing section); 13, 41a - 41f ... wafer setting surfaces; 14, 42a - 42f ... heaters (heating means); 15, 37a - 37f ... wafer holders; 17, 43b, 43d, 43f ... gas showers; 18, 44b, 44d, 44f ... outgassing surfaces; 19, 39b, 39d, 39f ... reaction gas introduction ports; 20, 26, 45b - 45f ... gas collectors; 21, 27, 40b - 40f ... gas discharge ports; 22, 38b, 38d, 37f ... gas dispersion units; 23, 46c ... infrared ray lamp holders; 24, 47c ... infrared ray lamps; 25, 39c, 39e ... gas introduction ports; 28, 38c ... infrared radiation means (processing means); 31 ... elevator; 33 ... rotary shaft; 34a - 34f ... arms; 35a, 35b ... slip rings; 36a, 36b ... collector rings; 38e ... ultraviolet radiation means (processing means); 48e ... mercury lamp holder; 49e ... mercury lamp; 50, 53, 55, 55a, 57 ... SiO₂ films; 51a, 51b, 58 ... interconnection layers; 52, 52a, 56, 56a ... BPSG films; 54a, 54b ... polysilicon layers or silicide layers.

## Claims

1. An apparatus for manufacturing a semiconductor device comprising:
a film forming section having a gas dispersion unit (22) for discharging a film forming gas from an outgassing surface (18);
a processing section having processing means (28) for processing the film after it has been formed, said processing means (28) being selected from infrared radiation means and ultraviolet radiation means;
a wafer holder (15, 37) provided with heating means (14, 42); and
moving means (33, 34) for moving the wafer holder (15, 37) holding a wafer (29, 32) so as to oppose the wafer (29, 32) on the wafer holder (15, 37) to the gas dispersion unit (22), halting the wafer holder (15, 37) during formation of the film, further moving the wafer holder (15, 37) after forming the film so as to oppose the wafer (29, 32) on the wafer holder (15, 37) to the processing means (28); and halting the wafer holder (15, 37) during processing the film.

2. An apparatus for manufacturing a semiconductor device according to claim 1, wherein a plurality of combinations of said film forming section and said processing section is provided.

3. A method for manufacturing a semiconductor device comprising steps of:
holding a wafer (29, 32) on a wafer holder (15, 37) provided with heating means (14, 42);
heating the wafer (29, 32) at a first temperature with the heating means (14, 42);
moving the wafer holder (15, 37) holding the wafer (29, 32) to a film forming section (11) while the wafer (29, 32) is kept heated so as to maintain the temperature of the wafer (29, 32) at the first temperature;
contacting a surface of the wafer (29, 32) with the film forming gas to form a film on the surface thereof while the wafer (29, 32) on the wafer holder (15, 37) is kept heated so as to maintain the temperature of the wafer (29, 32) at the first temperature;
moving the wafer holder holding the wafer to a processing section (12) while the wafer (29, 32) is kept heated so as to maintain the temperature of the wafer (29, 32) at the first temperature ; and
heating the wafer (29, 32) on the wafer holder (15, 37) with infrared radiation while the wafer (29, 32) is kept heated with the heating means (14, 42) so as to elevate the temperature of the wafer (29, 32) from the first temperature to a second temperature, thus performing heat processing of the formed film.

4. A method for manufacturing a semiconductor device comprising steps of:
holding a wafer (29, 32) on a wafer holder (15, 37) provided with heating means (14, 42);
heating the wafer (29, 32) at a predetermined temperature with the heating means (14, 42);
moving the wafer holder (15, 37) holding the wafer (29, 32) to a film forming section (11) while the wafer (29, 32) is kept heated so as to maintain the temperature of the wafer (29, 32);
contacting a surface of the wafer (29, 32) with the film forming gas to form a film on the surface thereof while the wafer (29, 32) on the wafer holder (15, 37) is kept heated so as to maintain the temperature of the wafer (29, 32);
moving the wafer holder (15, 37) holding the wafer (29, 32) to a processing section (12) while the wafer (29, 32) is kept heated so as to maintain the temperature of the wafer (29, 32);
radiating ultraviolet rays or discharging ozone onto the film after it has been formed while the wafer (29, 32) on the wafer holder (15, 37) is kept heated with the heating means (14, 42) so as to maintain the temperature of the wafer (29, 32), thus performing processing of the formed film.

## Patentansprüche

1. Einrichtung zur Herstellung eines Halbleiterbauelementes mit:
einer Filmbildungssektion mit einer Gasdispersionseinheit (22) zum Abgeben eines filmbildenden Gases von einer Ausgasungsoberfläche (18);
einer Verarbeitungssektion mit einer Verarbeitungseinrichtung (28) zum Verarbeiten des Films, nachdem er ausgebildet wurde, wobei die Verarbeitungseinrichtung (28) aus einer Infrarot-Strahlungseinrichtung und einer Ultraviolett-Strahlungseinrichtung ausgewählt wird;
einem Wafer-Halter (15, 37), der mit einer Erwärmungseinrichtung (14, 42) versehen ist, und
Bewegungseinrichtungen (33, 34) zum Bewegen des Wafer-Halters (15, 37), der einen Wafer (29, 32) hält, auf eine solche Weise, daß der Wafer (29, 32) auf dem Wafer-Halter (15, 37) der Gasdispersionseinheit (22) gegenübergelegt wird, zum Halten des Wafer-Halters (15, 37) während der Filmausbildung, zum Weiterbewegen des Wafer-Halters (15, 37) nach dem Ausbilden des Films, so daß der Wafer (29, 32) auf dem Wafer-Halter (15, 37) der Verarbeitungseinrichtung (28) gegenübergelegt wird; und zum Halten des Wafer-Halters (15, 37) während der Verarbeitung des Films.

2. Einrichtung zur Herstellung eines Halbleiterbauelements nach Anspruch 1, bei der mehrere Kombinationen der Filmausbildungssektion und der Verarbeitungssektion vorgesehen sind.

3. Verfahren zur Herstellung eines Halbleiterbauelements mit den folgenden Schritten:
Halten eines Wafers (29, 32) auf einem Wafer-Halter (15, 37), der mit einer Erwärmungseinrichtung (14, 42) versehen ist;
Erwärmen des Wafers (29, 32) auf eine erste Temperatur mit der Erwärmungseinrichtung (14, 43);
Bewegen des Wafer-Halters (15, 37), der den Wafer (29, 32) hält, zu einer Filmbildungssektion (11), während der Wafer (29, 32) weiter erwärmt wird, um so die Temperatur des Wafers (29, 32) bei der ersten Temperatur zu halten;
Bewegen des Wafer-Halters, der den Wafer hält, zu einer Verarbeitungssektion (12), während der Wafer (29, 32) mittels der Erwärmungseinrichtung (14, 42) weiter erwärmt wird, um so die Temperatur des Wafers (29, 32) von der ersten Temperatur auf eine zweite Temperatur zu erhöhen und so die Wärmebearbeitung des ausgebildeten Films durchzuführen.

4. Verfahren zur Herstellung eines Halbleiterbauelements mit den folgenden Schritten:
Halten eines Wafers (29, 32) auf einem Wafer-Halter (15, 37) der mit Erwärmungseinrichtungen (14, 42) versehen ist;
Erwärmen des Wafers (29, 32) auf eine vorbestimmte Temperatur mit der Erwärmungseinrichtung (14, 42);
Bewegen des Wafer-Halters (15, 37), der den Wafer (29, 32) hält, zu einer Filmbildungssektion (11), während der Wafer (29, 32) weiter erwärmt wird, um so die Temperatur des Wafers (29, 32) zu halten;
Kontaktieren einer Oberfläche des Wafers (29, 32) mit dem filmbildenden Gas, um einen Film auf dessen Oberfläche auszubilden, während der Wafer (29, 32) auf dem Wafer-Halter (15, 37) weiter erwärmt wird, um so die Temperatur des Wafers (29, 32) zu halten;
Bewegen des Wafer-Halters (15, 37), der den Wafer (29, 32) hält, zu einer Verarbeitungssektion (12), während der Wafer (29, 32) weiter erwärmt wird, um so die Temperatur des Wafers (29, 32) zu halten;
Abstrahlen von ultravioletten Strahlen oder Abgeben von Ozon auf den Film, nachdem er ausgebildet worden ist, während der Wafer (29, 32) auf dem Wafer-Halter (15, 37) mittels der Erwärmungseinrichtung (14, 42) weiter erwärmt wird, um so die Temperatur des Wafers (29, 32) zu halten, und das Verarbeiten des ausgebildeten Films durchzuführen.

## Revendications

1. Dispositif de fabrication d'un dispositif à semi-conducteurs comportant ;
une partie de formation de film ayant une unité de dispersion de gaz (22) pour décharger un gaz de formation de film depuis une surface de dégazage (18),
une partie de traitement ayant des moyens de traitement (28) pour traiter le film après qu'il ait été formé, lesdits moyens de traitement (28) étant sélectionnés parmi des moyens d'irradiation de rayons infrarouges et des moyens d'irradiation de rayons ultraviolets,
un support de tranche (15, 37) muni de moyens de chauffage (14, 42), et
des moyens de déplacement (33, 34) pour déplacer le support de tranche (15, 37) supportant une tranche (29, 32) de manière à mettre en vis-à-vis la tranche (29, 32) située sur le support de tranche (15, 37) et l'unité de dispersion de gaz (22), stopper le support de tranche (15, 37) pendant la formation du film, déplacer de plus le support de tranche (15, 37) après formation du film de manière à mettre en vis-à-vis la tranche (29, 32) située sur le support de tranche (15, 37) et les moyens de traitement (28), et stopper le support de tranche (15, 37) pendant le traitement du film.

2. Dispositif de fabrication d'un dispositif à semi-conducteurs selon la revendication 1, dans lequel on prévoit une pluralité de combinaisons de ladite partie de formation de film et de ladite partie de traitement.

3. Procédé de fabrication d'un dispositif à semi-conducteurs comportant les étapes consistant à :
supporter une tranche (29, 32) sur un support de tranche (15, 37) muni de moyens de chauffage (14, 42),
chauffer la tranche (29, 32) à une première température à l'aide des moyens de chauffage (14, 42),
déplacer le support de tranche (15, 37) supportant la tranche (29, 32) vers une partie de formation de film (11) alors que la tranche (29, 32) est maintenue chauffée de manière à maintenir la température de la tranche (29, 32) à la première température,
mettre en contact une surface de la tranche (29, 32) et le gaz de formation de film pour former un film sur la surface de celle-ci alors que la tranche (29, 32) située sur le support de tranche (15, 37) est maintenue chauffée de manière à maintenir la température de la tranche (29, 32) à la première température,
déplacer le support de tranche supportant la tranche vers une partie de traitement (12) alors que la tranche (29, 32) est maintenue chauffée de manière à maintenir la température de la tranche (29, 32) à la première température, et
chauffer la tranche (29, 32) située sur le support de tranche (15, 37) à l'aide d'une irradiation de rayons infrarouges alors que la tranche (29, 32) est maintenue chauffée à l'aide des moyens de chauffage (14, 42) de manière à élever la température de la tranche (29, 32) de la première température à une seconde température, en effectuant ainsi un traitement thermique du film formé.

4. Procédé de fabrication d'un dispositif à semi-conducteurs comportant les étapes consistant à :
supporter une tranche (29, 32) sur un support de tranche (15, 37) muni de moyens de chauffage (14, 42),
chauffer la tranche (29, 32) à une température prédéterminée à l'aide des moyens de chauffage (14, 42),
déplacer le support de tranche (15, 37) supportant la tranche (29, 32) vers une partie de formation de film (11) alors que la tranche (15, 37) est maintenue chauffée de manière à maintenir la température de la tranche (29 32),
mettre en contact une surface de la tranche (29, 32) et le gaz de formation de film pour former un film sur la surface de celle-ci alors que la tranche (29, 32) située sur le support de tranche (15, 37) est maintenue chauffée de manière à maintenir la température de la tranche (29, 32),
déplacer le support de tranche (15, 37) supportant la tranche (29, 32) vers une partie de traitement (12) alors que la tranche (29, 32) est maintenue chauffée de manière à maintenir la température de la tranche (29, 32),
irradier des rayons ultraviolets ou décharger de l'ozone sur le film après qu'il ait été formé alors que la tranche (29, 32) située sur le support de tranche (15, 37) est maintenue chauffée à l'aide des moyens de chauffage (14, 42) de manière à maintenir la température de la tranche (29, 32), en effectuant ainsi un traitement du film formé.
